# EUROPEAN PATENT SPECIFICATION

(11) **EP 1 982 955 B1**
(45) Date of publication and mention of the grant of the patent: **26.10.2011**
(21) Application number: 08005906.6
(22) Date of filing: 27.03.2008
(51) Int. Cl.: C01B 3/50, B01D 71/02, B01D 67/00, C23C 16/04

(54) **Method for producing hydrogen gas separation material**
Verfahren zur Herstellung von Wasserstoffgastrennmaterial
Procédé de production de matériel de séparation de gaz hydrogène

(30) Priority: 29.03.2007 JP 2007088049
(43) Date of publication of application: 22.10.2008
(73) Proprietor: NORITAKE CO., LIMITED, Nagoya-shi, Aichi 451-8501 (JP)
(72) Inventor: Yoshino, Yasushi, Nishi-ku Nagoya-shi Aichi 451-8501 (JP)
(74) Representative: Kramer - Barske - Schmidtchen

(56) References cited:
- JP-A- 2007 216 106
- US-A- 5 453 298
- US-A- 5 672 388
- M NOMURA ET AL: "Silicalite Membranes Modified by Counterdiffusion CVD Technique" INDUSTRIAL AND ENGINEERING CHEMICAL RESEARCH, vol. 36, 1997, pages 4217-4223, XP002565332 Online DOI: http://pubs.acs.org/doi/pdf/10.1021/ie9703 38a

## Description

### RELATED APPLICATION(S)

The application claims priority from Japanese Patent Application No. 2007-088049 filed on March 29, 2007.

### BACKGROUND OF THE INVENTION

### 1. Field of the Invention

The present invention relates to a method for the production of a hydrogen gas separator.

### 2. Description of the Related Art

Hydrogen gas separators are known to be used for the supply of hydrogen to fuel cells, catalytic membrane reactors, and the like. A typical method known for producing such hydrogen gas separators, for example, includes a process for forming a silica coat on a porous substrate composed of a ceramic material to reduce the size of the openings of the pores in the substrate. Typical examples of methods for forming such silica coats include chemical vapor deposition (CVD) and the sol gel method.

The documents related to the formation of silica coats by CVD include Japanese Patent Application Publication No. 2005-254161; Japanese Patent Application Publication No. 2006-239663; M. Nomura et al. Ind. Eng. Chem. Res. Vol.36 No.10, 1997, p.4217-4223; M. Nomura et al. Journal of Membrane Science 187, 2001, p.203-212; and S. Nakao et al. Microporous and MesoPorous Materials 37, 2000, p.145-152.
The documents on the formation of silica coats by the sol gel method include B. N. Nair et al. Journal of Membrane Science 135, 1997, p.237-243 and B. N. Nair et al. Adv. Mater. Vol. 10, No.3, 1998, p.249-252.

In the methods for forming silica coats by CVD given in the M. Nomura et al. Ind. Eng. Chem. Res. Vol.36 No.10, 1997, p.4217-4223; M. Nomura et al. Journal of Membrane Science 187, 2001, p.203-212; S. Nakao et al. Microporous and MesoPorous Materials 37, 2000, p.145-152; Japanese Patent Application Publication No. 2005-254161; and Japanese Patent Application Publication No. 2006-239663, a silica source such as tetraethyl orthosilicate (TEOS) or tetramethyl orthosilicate (TMOS) is vaporized and supplied from one side of a porous substrate, and ozone gas or oxygen gas is supplied from the other side of the substrate, so that they react in the pores of the substrate to form a silica coat (this type of CVD is referred to below as "counter diffusion CVD").

US 5,453,298 discloses a method for forming a permselective oxide membrane having hydrogen permselectivity, comprising: (a) forming a first reactant stream containing a first reactant of the formula RXₙ, wherein R is silicon, titanium, boron or aluminum, X is chlorine, bromine or iodine, and n is a number which is equal to the valence of R, (b) forming a second reactant stream containing water vapour, (c) providing a porous tube having an outside surface and an inside surface which define a tube wall and pores extending between the outside surface and inside surface, and (d) passing both the first and the second reactant streams along one of either the outside or the inside surface, but not both surfaces, of the porous tube and causing said reactant streams to react in the pores of the porous tube to form a nonporous layer of R-oxide in the pores of the porous tube, said nonporous layer being selectively permeable to hydrogen.

However, in the conventional production of hydrogen gas separators (silica coat formation) by counter diffusion CVD, the quality of the resulting hydrogen gas separators has tended to be inconsistent. One reason given for the inconsistent quality is that the thickness of silica coats formed by counter diffusion CVD (in other words, how dense the porous substrate can be made through the silica coat formation) is difficult to control. For example, if the silica coat is far thicker than the target thickness, the porous substrate will become too dense, and the pore diameter will therefore be too small, tending to result in insufficient hydrogen gas permeability.

An object of the present invention is to provide a method for consistently producing a hydrogen gas separator with a good performance balance through the formation of a silica coat by counter diffusion CVD.

The present invention provides a method in which a silica coat is formed on a porous substrate to produce a hydrogen gas separator. The method for producing a hydrogen gas separator includes a process for preparing the porous substrate. The method also includes a process for forming a silica coat on the substrate by means of chemical vapor deposition (CVD) in which a reaction is brought about between a silica source provided to one side of the substrate and an oxygen-containing gas supplied to the other side of the substrate. Here, the vapor deposition process is carried out using as the silica source a silicon compound (a) with Si-Z-Si bonds, wherein Z is oxygen (O) or nitrogen (N)' in the molecule.

When CVD (such as counter diffusion CVD) employs a silicon compound with Si-O-Si bonds or Si-N-Si bonds in the molecule as the silica source, excessive deposition (densification) is less likely to occur than when CVD is carried out using a silicon compound (a) such as TMOS or TEOS as the silica source. The size of the pores can thus be prevented from becoming too small as a result of the formation of the silica coat by CVD, or the likelihood can be reduced. That is, the use of the silicon compound (a) as the silica source enables more consistent production of hydrogen gas separators with pores of a size suitable for the separation of hydrogen gas (such as a good balance of hydrogen gas permeability and selectivity). The silica coat formed using the silicon compound (a) as the silica source also has great heat resistance and water vapor resistance. Accordingly, hydrogen gas separators obtained by the method disclosed herein are ideal for applications employed in atmospheres containing water vapor (such as separation of hydrogen gas produced by steam methane reforming, etc.).

According to the present invention, the silicon compound (a) includes disiloxanes represented by the following Formula (1):

(R¹)₃Si-O-Si(R²)₃ (1)

where R¹ and R² are each independently selected from alkyl groups having 1 to 3 carbon atoms (hereinafter, referred to such as "C₁ to C₃ alkyl groups") and C₂ to C₃ alkenyl groups,
and disilazanes represented by the following Formula (2):

(R³)₃Si-NH-Si(R⁴)₃ (2)

where R³ and R⁴ are each independently selected from C₁ to C₃ alkyl groups and C₂ to C₃ alkenyl groups.
Because these silicon compounds (a) have a suitable molecular size, the method of the invention for forming a silica coat by CVD using the above compounds (a) as the silica source allows consistent production of a hydrogen gas separator with a pore size suitable for the separation of hydrogen gas. In addition, because these silicon compounds (a) already have Si-O-Si bonds or Si-N-Si bonds in the molecule, but no alkoxysilyl or Si-X groups (X is a halogen atom), CVD (such as counter diffusion CVD) employing these compounds as the silica source makes it possible to avoid excessive deposition.

In a preferred embodiment of the method for producing a hydrogen gas separator disclosed herein, a porous substrate in the form of a film supported by a porous support is used as the porous substrate. For example, a porous film with a pore diameter of about 2 nm to 20 nm (typically a porous film made of a ceramic material, specifically, a porous ceramic film) provided on the surface of a porous support (typically a substrate made of a ceramic material, specifically, a porous ceramic support) with a pore diameter of about 50 nm to 1000 nm (that is, about 0.05 µm to 1 µm) can preferably be used as the porous substrate. The pores of the substrate can be efficiently and appropriately shrunk by forming a silica coat through CVD employing the above silica sources on the porous substrate having the above pore diameter. A hydrogen gas separator with a pore size suitable for the separation of hydrogen gas can therefore be consistently and efficiently produced. Since the separator comprises a support that reinforces the porous substrate, the substrate can be made thinner while having the necessary strength. It is thus possible to produce a hydrogen gas separator having a better balance of hydrogen gas permeability and selectivity.

In another aspect, the invention disclosed herein is intended to provide a method for producing a hydrogen gas separator which comprises the processes for preparing a porous support with a pore diameter of about 50 nm to 1000 nm, forming a porous substrate as a film (porous film) with a pore diameter of about 2 nm to 20 nm on the surface of the porous support, and forming a silica coat on the substrate by means of chemical vapor deposition in which a reaction is brought about between a silica source provided to one side of the substrate and an oxygen-containing gas supplied to the other side of the substrate (typically chemical vapor deposition using as a silica source a silicon compound (a) having Si-Z-Si bonds (Z is O or N) in the molecule). In yet another aspect, the invention provides a hydrogen gas separator equipped with a porous support having a pore diameter of about 50 nm to 1000 nm and a hydrogen gas separation film having a pore diameter of no more than 1.0 nm (typically about 0.3 nm to 0.6 nm) obtained by forming a silica coat on a porous substrate film (porous film) with a pore diameter of about 2 nm to 20 nm provided on the surface of the support. The above silica coat can preferably be formed by chemical vapor deposition in which a reaction is brought about between a silica source provided to one side of the substrate and an oxygen-containing gas supplied to the other side of the substrate. According to the present invention, the silica source is a silicon compound (a) having Si-Z-Si bonds, wherein Z is O or N, in the molecule, which is selected from the group of compounds represented by the above Formula (1) and Formula (2).

The vapor deposition process is preferably carried out to form a silica coat so that the activation energy of the hydrogen gas permeating the resulting hydrogen gas separator is no more than about 10 kJ/mol (for example, about 1 kJ/mol to 10 kJ/mol) at a temperature between 300 °C and 600 °C. Activation energy is typically determined from an Arrhenius plot of the hydrogen gas permeability in that temperature range. Activation energy that is too high will tend to result in an increase in temperature-dependency of the hydrogen gas permeability. For instance, it may exhibit good hydrogen gas permeability at 600 °C, but significantly lower hydrogen gas permeability at 300 °C. In the vapor deposition process, the above silicon compound (a) is used as the silica source and the vapor deposition process is carried out in such a way as to keep the activation energy within the above range, thereby making it possible to produce a hydrogen gas separator that provides good hydrogen gas separation performance (such as a good balance of hydrogen gas permeability and selectivity) over a broad temperature range.

The silica coat may be formed using a silicon compound (a) alone as the silica source, or may be formed using a silicon compound (a) and another compound (a compound that is different from silicon compound (a), specifically, a silicon compound without Si-O-Si bonds or Si-N-Si bonds in the molecule), either simultaneously or in any order. For example, the vapor deposition process may include a first vapor deposition step of using as the silica source the compound (a) and a second vapor deposition step of using as the silica source a silicon compound (b) that is different from the compound (a). Such an embodiment will produce consistently a hydrogen gas separator with a pore size suitable for hydrogen gas separation. Such an embodiment will also provide a hydrogen gas separator having more desirable properties (such as higher selectivity) through an appropriate combination of the silicon compound (a) and silicon compound (b).

### BRIEF DESCRIPTION OF THE DRAWINGS

Figure 1 is a schematic perspective view of the process for forming a silica coat on a porous substrate in a preferred embodiment of the invention.

Figure 2 is a schematic detail of the portion circled by the dashed line II in Figure 1.

Figure 3 is another schematic detail of the main portion of Figure 2.

Figure 4 is a schematic structural illustration of a preferred embodiment of a CVD device used in the vapor deposition process.

Figure 5 is a schematic flow chart of the method for producing the hydrogen gas separator in the examples.

Figure 6 is a plot showing the relationship between reaction time and hydrogen gas permeation activation energy.

### DETAILED DESCRIPTION OF THE PREFERRED EMBODIMENT(S)

Preferred embodiments of the invention are given below. Matters which are not specifically mentioned in the Specification but which are necessary to working the invention will be understood as matters of design by persons with ordinary skill in the art based on the prior art in the field. The present invention can be worked based on details disclosed in the Specification and common general technical knowledge in the field.

The material of the porous substrate used in the method for producing a hydrogen gas separator disclosed herein is one that allows a silica coat to be formed by CVD and that can withstand the environment in which it will be used (that is, during hydrogen gas separation). Various types of ceramic materials such as metal oxides, carbides, and nitrides can be employed. Examples of ceramics that may preferably be used include α-alumina, γ-alumina, silica, zirconia, silicone nitride, silicon carbide, titania, calcia, and various types of zeolite. Porous substrates from composites or mixtures of these may also be used.

The suitable pore size of the porous substrate is such that when a silica coat is disposed by the vapor deposition process described below, the coated pores are to have a diameter appropriate for hydrogen gas separation. For example, preferably used is a porous substrate with a pore diameter (pore diameter distribution peak and/or mean pore diameter; the pore diameter distribution peak can typically approximate the mean pore diameter) of about 100 nm or smaller. More preferably used is a porous substrate with a pore diameter of about 50 nm or smaller (such as about 20 nm or smaller, or about 10 nm or smaller). A porous substrate with a pore size greater than the above range will require a longer vapor deposition time to adjust the pore diameter to a size suitable for hydrogen gas separation, slowing down the hydrogen gas separator production efficiency. On the other hand, if the pore diameter of the porous substrate is smaller than the above range, the silica coat needed to adjust the pore diameter to a size suitable for hydrogen gas separation would be too thick, and the silica coat thickness (and, hence, the properties of the resulting hydrogen gas separator) would tend to be inconsistent A porous substrate with a pore diameter of about 1 nm or greater (such as about 1 nm to 100 nm) is therefore preferred, and a porous substrate with a pore diameter of about 2 nm or greater (such as about 2 nm to 20 nm) is even more desirable. For example, the use of a porous substrate with a pore diameter of about 4 nm to 20 nm (especially about 4 nm to 10 nm) is preferred in consideration of the ease of porous substrate production, silica coat formation efficiency (hydrogen gas separator production efficiency), and the like. A porous substrate with a narrow pore diameter distribution (in other words, a highly uniform pore size) is preferred.

The configuration of the porous substrate is not particularly limited and can assume a variety of forms as befits the intended application. As an example of a desirable form which would be advantageous for further enhancing a high level of hydrogen gas permeability, a porous substrate in the form of a film (thin plate) can preferably be employed. The use of a porous substrate film (porous film) that is about 0.1 µm to 10 µm thick (and preferably about 0.1 µm to 5 µm) is preferred. The porosity (void ratio) of the porous substrate is normally suitable in the range of about 20% to 60 % (volume ratio). A porous substrate with a porosity of about 30% to 40 %, for example, can be preferably used.

In a preferred embodiment, such a porous substrate film (thin plate) is provided on the surface of a porous support. Using such a porous substrate backed by a porous support (hereinafter, may be referred to simply as a "support") will allow the substrate to be made thinner while preserving the necessary strength. The thinning of the substrate will lead to the formation of a hydrogen gas separator with greater hydrogen gas separation performance (such as greater hydrogen gas permeability and/or selectivity, or a better balance of hydrogen gas permeability and selectivity at a higher level).

The shape of the support is not particularly limited, and can be a tube, film (thin plate), monolith, honeycomb, polygonal flat plate, or other three-dimensional shape. Tubular shapes are preferred among these, being readily adaptable as hydrogen gas separation modules to reactors such as reformers. For example, a porous structure is preferably prepared in which a porous substrate film (porous film) is provided on the outer peripheral surface and/or inner peripheral surface (typically only the outer peripheral surface) of a tubular porous support, and the structure is subjected to the vapor deposition process described below (counter diffusion CVD). A support of the desired shape can also be produced by a conventionally well known molding technique (such as extrusion molding, press molding, or casting) or ceramic sintering technique. These techniques in themselves will not be further elaborated as they do not characterize the invention in any way.

The diameter of the support pores is not particularly limited, provided that the permeation of gas such as oxygen and hydrogen is not significantly hindered. A suitable support has a pore diameter greater (typically about 2 to 50 times greater, such as about 5 to 20 times greater) than the pore diameter of the porous substrate (porous film). For example, a support preferred for use has a pore diameter distribution peak and/or mean pore diameter (pore diameter) of about 0.01 µm to 10 µm with 0.05 µm to 1 µm being more preferred. A support with a narrow pore diameter distribution is desirable. The support porosity can be, for example, about 30 % to 70 % (volume ratio), and a porosity of about 35.% to 60 % is normally preferred. The support should be made thick enough for the porous substrate to be appropriately supported while preserving the desired mechanical strength as befits the intended application. Although not particularly limited, the support can be about 100 µm to 10 mm thick, for example, when the porous substrate is 0.1 µm to 5 µm.

The same material used for the aforementioned porous substrate can be used as the material for the support. The material forming the porous substrate and the material forming the support may be the same or different. For example, preferred is a combination of a support formed of α-alumina and a porous substrate formed of γ-alumina, where the support typically has a pore diameter of 0.05 µm or greater, such as about 0.05 µm to 1 µm, and the substrate typically has a pore diameter of 2 nm or greater, such as about 2 nm to 20 nm. A porous structure having such a configuration can be preferably subjected to the vapor deposition process described below (counter diffusion CVD) to form a silica coat on the porous structure (typically, on the porous substrate constituting the structure), resulting in the production a hydrogen gas separator.

The porous support used in the method disclosed herein may also assume an asymmetrical structure, for example, wherein a porous layer with a smaller pore diameter is laminated on the surface of another porous layer with a relatively larger pore diameter (typically, the surface on the side where the porous substrate is provided). The support may also have a structure with three or more laminated porous layers (preferably laminated in such a way that the pore diameter becomes smaller toward the top layer side, that is, the side on which the porous substrate is provided). In this type of layered support, the pore diameter of the uppermost porous layer (that is, the porous layer disposed directly under the porous substrate) is preferably about 0.05 µm to 0.5 µm. The materials of the layers may be the same or different. For example, in a preferred embodiment, the porous structure subjected to the vapor deposition process (counter diffusion CVD) described below comprises a porous support composed of an α-alumina porous layer with a relatively small pore diameter (that is, more dense) laminated on an α-alumina porous layer with a relatively greater pore diameter and a γ-alumina substrate (porous film) provided on the surface of the support (typically, on the surface of the α-alumina layer having the smaller pore diameter).

The method for forming the porous film (porous substrate) on the surface of the support is not particularly limited, and a variety of conventionally well known techniques can be adopted. For example, a common sol gel method can preferably be employed as a suitable method for forming the porous ceramic film (porous substrate) having the desirable pore diameter described above. In a typical embodiment of such a sol gel method, a sol containing a ceramic precursor in accordance with the composition of the target ceramic film (such as a corresponding metal alkoxide) is prepared, and the sol is applied to a porous support by dip coating or the like and dried, forming a gel film containing the ceramic precursor. The gel film is fired to form a porous ceramic film on the surface of the porous substrate. A porous structure having a porous ceramic film on a porous substrate (porous substrate) can thus be obtained in this manner.

A γ-alumina film can be formed as the porous substrate on the surface of a porous support, for example, using the sol gel method in the following manner. Specifically, a boehmite sol is produced through the hydrolysis of an aluminum alkoxide (preferably an alkoxide with about C₁ to C₃, such as isopropoxide) and acid peptization. The boehmite sol is applied to desired areas on the porous substrate (such as outer peripheral surface of tubular porous support). the material is preferably applied by dip coating, for example. The dipping can be carried out for about 5 seconds to 30 seconds, for example. The support may be picked up out of the sol at a rate of about 0.5 mm/sec to 2.0 mm/sec, for example. The support is dried for about 6 to 18 hours at a temperature of about room temperature to 60 °C, and is then fired for about 5 hours to 10 hours at a temperature of about 400 °C to 900 °C to form a γ-alumina film. Part or the entire series of the procedures of sol-coating, drying, and firing can be carried out multiple times as needed. Ordinarily, the γ-alumina film is preferably formed by repeating these procedures.

An example of another suitable method that may be employed to form a porous ceramic film with the above desirable pore diameter on the surface of a support (porous substrate) is to apply to a support a dispersion of fine particles of the ceramic film constituent (preferably ceramic particles with a mean particle diameter of about 20 nm to 200 nm) in a suitable liquid medium which is then dried and fired. When this method is employed to form a γ-alumina film on the surface of a porous support, for example, γ-alumina particles with a mean particle diameter of 20 nm to 200 nm are dispersed in a liquid medium (preferably water), and the dispersion is applied by dip coating (preferably, for example, at a dipping time of about 5 seconds to 30 seconds and/or a pick up rate of about 0.5 mm/sec to 2.0 mm/sec) to the desired parts of the porous support (such as the outer peripheral surface of a tubular porous support). This is dried for about 6 hours to 18 hours at a temperature of about room temperature to 60 °C, and is then fired for about 5 hours to 10 hours at a temperature of about 400 °C to 900 °C, forming a γ-alumina film. Part or the entire series of the procedures of coating, drying, and firing can be carried out multiple times as needed. Ordinarily, the γ-alumina film is preferably formed by repeating these procedures.

In the vapor deposition process of the method disclosed herein, a silica coat is formed on the porous substrate by chemical vapor deposition (sometimes referred to below as "counter diffusion CVD") in which a reaction is brought about between a silica source provided to one side of the porous substrate and an oxygen-containing gas supplied to the other side of the substrate. The silica source is typically supplied as a gas (gaseous silica) to one side (first surface) of the porous substrate. The gaseous silica is brought into contact at elevated temperature with the oxygen-containing gas that diffuses through the substrate from the other side (second surface) through the pores to the first side of the substrate, so that they react (typically, by thermal decomposition of the gaseous silica), forming the silica coat on the porous substrate (chemical vapor deposition). The locations where the silica coat is formed can vary, depending on the locations where the gaseous silica and oxygen-containing gas come into contact. The counter diffusion CVD is preferably carried out in such a way that the gaseous silica and oxygen-containing gas come into contact primarily in the pores of the porous substrate and/or near the pore openings on the first surface of the substrate (near or around the pore entrances). This will allow the size of the substrate pores to be efficiently decreased to the size appropriate for hydrogen gas separation.

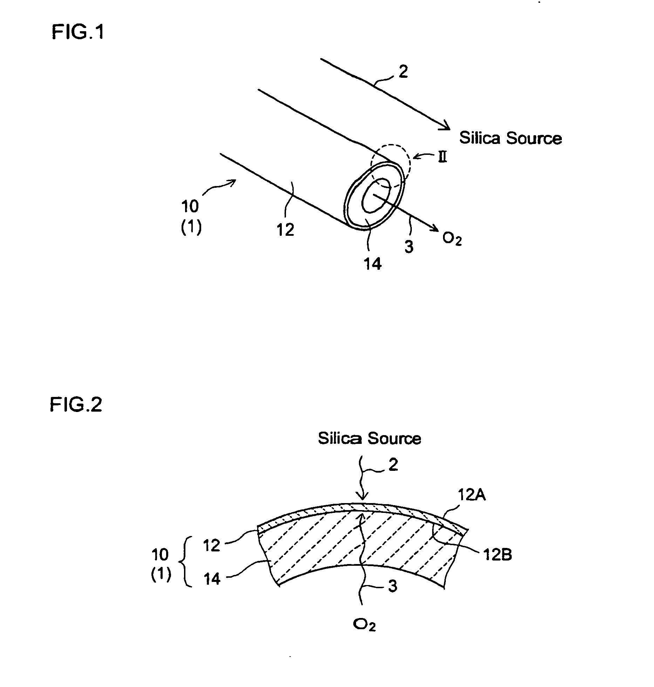

In a preferred embodiment, as shown in Figure 1, the porous substrate subjected to the above counter diffusion CVD is a porous substrate (porous film) 12 provided on the surface of a porous support 14, which can be of a layered structure as described above. In this embodiment, the vapor deposition process can be carried out in such a way that a silica coat is formed through counter diffusion CVD on a porous structure 10 having the porous substrate 12 on the surface of the support 14. Although not particularly limited, the oxygen-containing gas is preferably supplied from the support side of the porous structure, and the gaseous silica is supplied to the substrate side to carry out counter diffusion CVD. For example, as illustrated in Figure 1, when counter diffusion CVD is applied to the tubular porous structure 10, wherein the porous film 12 is formed on the outer peripheral surface of the tubular support 14, a gaseous silica source 2 passes along the outer wall of the porous structure 10, and an oxygen-containing gas 3 will pass through the interior (hollow portion) of the porous structure 10.

The formation of a silica coat on a porous substrate by the counter diffusion CVD carried out in this manner will be described with reference to the schematic illustrations of Figures 1 through 3. To facilitate an understanding of the invention, the example will involve the use of the porous structure 10 having the structure shown in Figure 1, where the porous substrate film (porous film) 12 is provided on the outer peripheral surface of the tubular porous support 14, but the porous substrate in the method of the invention is not limited to just this embodiment.
When the oxygen-containing gas 3 (such as O₂ gas) flows into the hollow portion of the tubular porous structure 10 shown in Figure 1, at least some of the oxygen-containing gas 3 is diffused from the inner peripheral side of the support 14 through the pores of the support 14 to the outer peripheral side, as illustrated in Figure 2, which is a detail of the dashed line part II in Figure 1, thereby reaching the inner peripheral surface (the second surface) 12B of the porous substrate 12, and is furthermore diffused through the pores of the porous substrate 12 toward the outer side (outer peripheral surface 12A of the porous substrate 12). Meanwhile, at least some of the gaseous silica 2 flowing (provided) to the outer periphery of the porous structure 10 is diffused from the outer peripheral surface (the first surface) 12A of the porous substrate 12 through the pores of the substrate 12 toward the inner peripheral side (inner peripheral surface 12B). The gases 2 and 3 diffusing toward each other from the surfaces 12A and 12B of the porous substrate 12 thus come into contact and react to result in the formation of the silica coat.

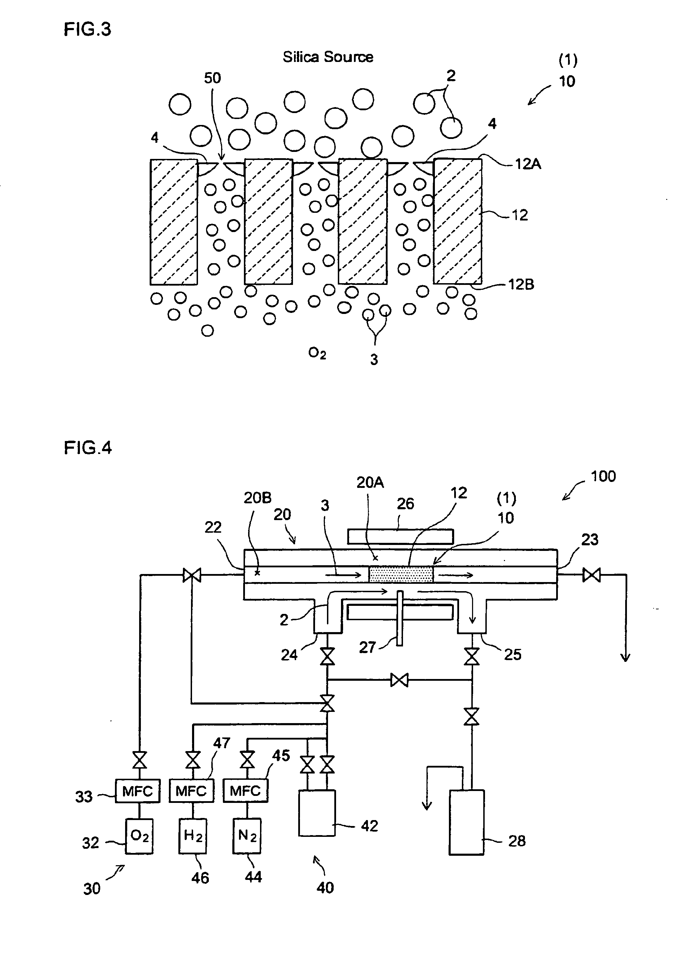

As illustrated in Figure 3, this counter CVD is preferably carried out in such a way that the gaseous silica 2 and oxygen-containing gas 3 diffusing counter to each other come into contact primarily in pores 50 of the porous substrate 12 and/or near the openings of the pores 50 on the first side 12A, so that the silica coat 4 is formed in the pores 50 or near their openings. Usually, the gaseous silica 2 has a greater molecular size than an oxygen-containing gas 3 such as O₂ gas. By taking advantage of this molecular size difference between the gases 2 and 3 and by appropriately setting the size (pore diameter) of the pores 50, the silica coat 4 can be efficiently formed in these places. The size of the pores 50 can be suitably made smaller (to a size suitable for hydrogen gas separation) with the silica coat 4, giving a hydrogen gas separator 1.
In contrast to the example illustrated in Figures 1 through 3, a silica coat may also be formed by allowing the oxygen-containing gas 3 to flow along the outer wall of the porous structure 10, and the gaseous silica 2 to flow into the interior (hollow portion) of the porous structure 10.

In the method disclosed herein, a silicon compound (a) having Si-Z-Si bonds, wherein Z is O or N, in the molecule, which is selected from the disiloxanes represented by Formula (1) above and disilazanes represented by Formula (2) above, is used as the silica source for forming the silica coat in the vapor deposition process. The silicon compound (a) produces silica (SiO₂) upon reaction (typically through thermal decomposition) with the oxygen-containing gas described below. Any kind of said silicon compounds (a) having a Si-Z-Si bond may be used as a silica source, and two or more kinds of silicon compounds (a) having such bonds may also be used either simultaneously or in any sequence as the silica source. According to the present invention, a silicon compound with only one Si-Z-Si bond (specifically, disiloxanes or disilazanes) is used as the silica source because of the vaporization ease, the availability of the starting materials, the appropriate molecular size for forming silica coats suited to hydrogen gas separation, and so on.

R¹ and R² in Formula (1) can each be independently selected from C₁ to C₃ (and preferably C₁ to C₂) alkyl groups and C₂ to C₃ alkenyl groups. That is, R¹ and R² may be the same or different groups. The same is true of R³ and R⁴ in Formula (2). The three R¹ in Formula (1) may also all be the same, two may be the same and one may be different, or all three may be different from each other. The same is true of R², R³, and R⁴. Desirable examples of the silicon compounds (a) of Formulas (1) and (2) include hexamethyl disiloxane (HMDS), 1,3-divinyl tetramethyl disiloxane, hexamethyl disilazane, 1,3-divinyl tetramethyl disilazane, and the like. Other examples of compounds that are silicon compounds (a) with Si-Z-Si bonds in the molecule and that can be used as the silica sources include 1,3-dioctyl tetramethyl disiloxane and heptamethyl disilazane.

In the vapor deposition process disclosed herein, in addition to said silicon compound (a) with Si-Z-Si bonds in the molecule, can also be used as a silica source a silicon compound (b) that is not classified as a silicon compound (a) (i.e., that does not have any Si-Z-Si bonds in the molecule) but that is capable of producing silica (SiO₂) upon reaction with the oxygen-containing gas described below. Examples of such silicon compounds (b) include tetraalkoxysilanes (typically about C₁ to C₄ tetra-lower alkoxysilanes) such as tetramethoxysilane (TMOS) and tetraethoxysilane (TEOS); trialkoxysilanes such as methyl trimethoxysilane, n-octyltriethoxysilane, n-decyltrimethoxysilane, and m,p-ethylphenethyl-trimethoxysilane; dialkoxysilanes such as diphenyl diethoxysilane; monoalkoxysilanes such as octyldimethyl methoxysilane; halosilanes such as SiCl₄; and silane (SiH₄).
A silicon compound (b) can be used at the same time as a silicon compound (a) (such as a gaseous mixture of a silicon compound (a) and silicon compound (b) supplied to one side of the porous substrate) or separately from the silicon compound (a) (alternating the silica sources). The above vapor deposition process can be carried out in an embodiment, for example, including a first vapor deposition step in which a silicon compound (a) is used as a silica source and a second vapor deposition step in which a silicon compound (b) is used as a silica source. Either the silicon compound (a) or silicon compound (b) may undergo vapor deposition first. For example, an embodiment in which the first vapor deposition step is followed by the second vapor deposition step is preferably employed.

A feature of the method of production related to this invention is that at least a silicon compound (a) is used as a silica source in the vapor deposition process (counter diffusion CVD), and the use of a silicon compound (b) as a silica source is optional. The method disclosed herein is preferably implemented without the use of a silicon compound (b) (in other words, only the silicon compound (a) is used as the silica source) to achieve the intended effects. It is desirable to use a silicon compound (b) as an aid predicated on the use of a silicon compound (a). Such auxiliary use (such as the use of a tetra-lower alkoxysilane), for example, can modify (reform) the surface of the silica coat formed with a silicon compound (a), thereby further enhancing, for example, the hydrogen gas selectivity. When modifying the surface, it is preferable to carry out the first vapor deposition step with a silicon compound (a) as the silica source followed by the second vapor deposition step with a silicon compound (b) as the silica source.

As the oxygen-containing gas in the vapor deposition process, can be used a variety of gases that have at least one oxygen atom per molecule and that are capable of producing SiO₂ upon reaction with a silica source (typically by thermal decomposition of the silica source). For example, one or two or more oxygen-containing gases selected from oxygen allotrope gases (such as O₂ gas and O₃ gas) as well as H₂O gas (water vapor) can be used. Of these, the use of O₂ gas is particularly desirable. The above oxygen-containing gases may be supplied to the second surface of the porous substrate as such (that is, 100 % in the form of an oxygen-containing gas), or as a gaseous mixture with an inert gas (such as one or more selected from N₂ gas, Ar gas, He gas, Ne gas, etc.), for example. In the latter case, the oxygen-containing gas in the gaseous mixture is preferably O₂ and/or O₃ gas. The concentration of the oxygen-containing gas in the gaseous mixture is preferably 25 mass% or greater, for example (more preferably 50 mass% or greater, and still more preferably 70 mass% or greater).

The silica coat is typically formed in the vapor deposition process under conditions in which the porous substrate is heated to a temperature of about 200 °C to 700 °C. Ordinarily, the heating temperature (film-producing temperature or reaction temperature) is preferably about 400 °C to 700 °C. If the silica coat is formed at too low a temperature, the silica coat production efficiency will suffer or the silica coat may not be properly formed. A film-forming temperature that is too much higher than the above range may lead to a deterioration of the porous substrate. The desirable film-producing temperature can also vary depending on the type of silica source used, type of oxygen-containing gas, amounts of silica source and amount of oxygen-containing gas supplied, and so forth.
The time duration for the vapor deposition of the silica source is not particularly limited and may be set so that the size of the pores of the porous substrate can be properly shrunk with the silica coat formed. For example, the vapor deposition time (film-forming time or reaction time) can be set to about 3 minutes to 180 minutes, with about 3 minutes to 60 minutes usually preferred. If the film-forming time is too long, the hydrogen gas separator production efficiency tends to suffer, and if the time is too short, the hydrogen gas separator performance tends to become inconsistent.

The vapor deposition process in the method disclosed herein can preferably be carried out using a CVD device 100 equipped with the schematic structure illustrated in Figure 4, for example. Here, the vapor deposition process is described with an example where the process is applied to the porous structure 10, which comprises the porous film 12 formed on the outer surface of the tubular support 14 as shown in Figure 1. The CVD device 100 illustrated in Figure 4 is equipped with a reaction tube 20 on which the porous structure 10 having the above configuration is disposed. Generally speaking, the reaction tube 20 has a coaxial double-tube structure. The porous structure 10 is disposed generally coaxially with the reaction tube 20 so as to fill part of the inner tube of the double-tube structure. The porous structure 10 is thus disposed in such a way that the outer peripheral surface (that is, the porous film 12) faces an outer gas channel 20A partitioned between the inner tube (and porous structure 10) and outer tube of the reaction tube 20. The inner peripheral surface (that is, the porous support 14) of the porous structure 10 faces an internal gas channel 20B partitioned by the inner tube (and porous structure 10) of the reaction tube 20. The area between the inner tube and outer tube is sealed at both ends of the reaction tube 20, so that the both ends of the length of the external gas channel 20A are closed.
A tubular heater (such as an electric furnace) 26 is placed on the outer periphery of the reaction tube 20. The output of the heater 26 is adjusted, for example, based on the input from a temperature detector 27, which detects the temperature inside the reaction tube 20, allowing the temperature of the reaction tube 20 to be controlled in accordance with the prescribed temperature profile (so as to ensure a constant temperature, for example).

An oxygen-containing gas supply system 30 and silica source supply system 40 are connected to the reaction tube 20. The oxygen-containing gas supply system 30 comprises an oxygen-containing gas (here, O₂ gas) reservoir 32, which supplies O₂ gas 3, and further comprises a mass flow controller 33, which controls the flow rate of the O₂ gas 3, so that the gas 3 can be introduced into the internal gas channel 20B from an inner tube inlet 22 provided at one longitudinal end of the inner tube. By-products (such as water and carbon dioxide) resulting from the thermal decomposition of the silica source and unreacted oxygen-containing gas are discharged from an inner tube outlet 23 provided at other longitudinal end of the inner tube.
The silica source supply system 40 is equipped with a vaporizer 42 that can store the silica source (typically as a liquid) inside. The system 40 further comprises a N₂ gas reservoir 44 to supply N₂ and a mass flow controller 45 to control the flow rate of N₂ gas, so that N₂ gas can be introduced into the vaporizer 42, where the N₂ gas is bubbled to vaporize the silica source, and the vaporized silica source 2 is introduced together with the N₂ gas into the external gas channel 20A from an outer tube inlet 24 provided at one end of the outer tube. The unreacted silica source, N₂ gas, and the like are discharged from an outer tube outlet 25 provided at the other end of the outer tube. The unreacted silica source from the outer tube outlet 25 is recovered by a trap (such as a cold trap) 28.

Formation of a silica coat (vapor deposition process) can be carried out using the CVD device 100 having the above structure in the following manner, for example. That is, the heater 26 is operated to heat the interior of the reaction tube 20 to a prescribed temperature (preferably 200 °C to 700 °C, such as 550 °C to 600 °C). As the temperature is maintained, the O₂ gas 3 is supplied from the O₂ reservoir 32 at a prescribed flow rate (gas flow rate) into the internal gas channel 20B (the second surface 12B of the porous substrate 12). Meanwhile, N₂ gas is supplied from the N₂ reservoir 44 at a prescribed flow rate to the vaporizer 42 to vaporize the silica source, and the vaporized silica source (gaseous silica) 2 and N₂ gas are supplied to the external gas channel 20A (first side 12A of the porous substrate 12). This way, the O₂ gas 3 and gaseous silica 2 are diffused counter to each other across the thickness of the porous substrate 12 in the reaction tube 20, and the silica source in contact with the O₂ gas 3 is thermally decomposed, allowing a silica coat to be formed (produced) primarily in the pores of the porous substrate 12. The O₂ gas and N₂ gas can be supplied each at about 100 mL/min to 1000 mL/min, for example. The silica source stored inside the vaporizer 42 can also be pre-heated as needed. For example, the silica source may be heated to a temperature of about 30 °C to 80 °C in the vaporizer 42.

The aforementioned vapor deposition process is preferably carried out in such a way that the activation energy required for the hydrogen gas to permeate the gas separator comprising the silica coat formed through the process described above is no more than 10 kJ/mol (such as about 1 kJ/mol to 10 kJ/mol) at a temperature between 300 °C and 600 °C. Various conditions such as the type of silica source that is used, the diameter of the porous substrate pores, the type and feed rate of oxygen-containing gas, the heating temperature of the reaction tube 20 (film-forming temperature), and reaction time (film-forming time) should be set up so as to bring about such a value.

### EXAMPLES

The present invention will be further elaborated by, but is in no way limited to, the following illustrative examples.

### <Example 1>

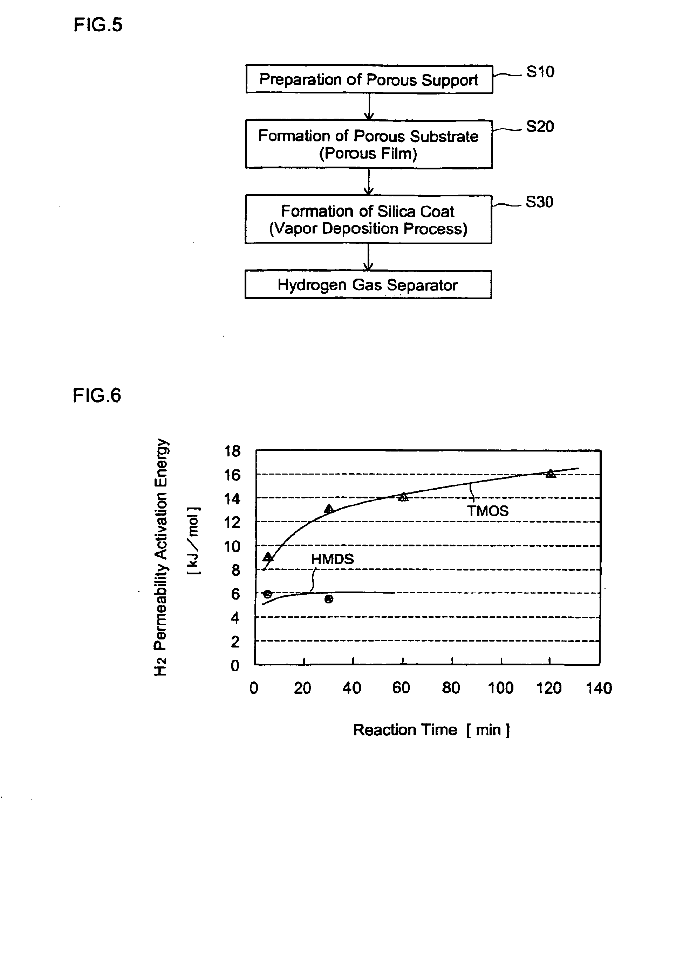

A hydrogen gas separator having the structure schematically illustrated in Figure 1 was produced by the procedures given in Figure 5.
That is, α-alumina powder with a mean particle diameter of about 1 µm was kneaded along with water and an organic binder to prepare an extrusion molding paste. The paste was molded using a commercially available extruder, was dried, and was then fired in the atmosphere, to prepare a porous support 14 (α-alumina support) in a tubular shape (with outside diameter of 10 mm, inside diameter of 7 mm, and length of 50 mm) (step S10). The mean pore diameter of the support 14, as determined by general mercury penetration, was about 150 nm.

A porous film (porous substrate) 12 was then formed on the surface of the resulting α-alumina support 14 (step S20). In particular, a boehmite sol was produced through the hydrolysis of aluminum isopropoxide and acid peptization. The α-alumina support 14 (both ends of the tube were temporarily blocked so as to prevent the sol from penetrating into the hollow portion) was dipped for 10 seconds in the boehmite sol, and the support 14 was then taken up at a rate of about 1.0 mm/sec out of the sol, so that the outer peripheral surface of the support 14 was dip-coated with the boehmite sol. This was dried overnight (about 12 hours) at 60 °C and was then fired for 3 hours at 600 °C in the atmosphere, giving a γ-alumina porous film (γ-alumina film) 12. This resulted in a porous structure 10 which comprised the γ-alumina film 12 formed on the outer peripheral surface of the α-alumina support 14. The γ-alumina film 12 was about 2 µm thick, and the peak pore diameter, as determined by general nitrogen absorption, was 4 nm to 6 nm. The γ-alumina film 12 obtained through the firing process at 600 °C may be referred to below as the "γ-alumina substrate (600 °C)".

The resulting porous structure 10 was set up on a CVD device having the schematic structure given in Figure 4, and counter diffusion CVD was brought about using hexamethyl disiloxane (HMDS) as the silica source to form a silica coat 4 on the γ-alumina film 12 constituting the structure 10, as illustrated in Figure 3 (Step S30). The counter diffusion CVD was carried out at a reaction temperature (silica coat-forming temperature) of 600 °C, a reaction time (silica coat-forming time) of 5 minutes, an N₂ gas feed rate of 200 mL/min, and an O₂ gas feed rate of 200 mL/min. The hydrogen gas separator of Example 1 was thus produced. The HMDS heated to about 45 °C in the vaporizer 42 was vaporized through N₂ gas bubbling.

The hydrogen gas permeability and nitrogen gas permeability of the resulting hydrogen gas separator 1 were measured, and the permeability coefficient ratio between the hydrogen gas and nitrogen gas (H₂/N₂) was calculated based on the gas permeability results. Here, the permeability coefficient ratio (H₂/N₂) refers to the proportion between the hydrogen gas permeability and nitrogen gas permeability under the same conditions, that is, the ratio (molar ratio) of the hydrogen gas permeability to the nitrogen gas permeability under the same conditions. Here, the hydrogen gas permeability [mol/m²•s•Pa] and nitrogen gas permeability [mol/m²•s•Pa] are each represented as the hydrogen gas permeability [mol] and nitrogen gas permeability [mol] per unit time (1 sec) and unit membrane surface area (1 m²) at a pressure differential (difference between pressure on the gas supply side and pressure on the gas permeation side across the hydrogen gas separator 1) of 1 Pa.

The hydrogen gas permeability and nitrogen gas permeability were measured in the following manner using the CVD device 100 shown in Figure 4. In detail, the heater 26 was operated as needed to adjust the interior of the reaction tube 20 to a prescribed measuring temperature, and N₂ gas and H₂ gas were supplied from the N₂ reservoir 44 and H₂ reservoir 46 to the external gas channel 20A at prescribed flow rates controlled by the mass flow controllers 45 and 47. At that time, the pressure differential between the outer peripheral side and inner peripheral side of the hydrogen gas separator 1 was set to 2.0 × 10⁴ Pa (0.2 atm). As the gas flow rate on the permeation side (that is, internal gas channel 20B) was determined by a soap-film flow meter (not shown), the target gas composition was analyzed by a gas chromatograph (not shown) equipped with a TCD detector. The hydrogen gas and nitrogen gas permeability were calculated from the following equation: Q=A/((Pr-Pp)•S•t). Here, Q is the gas permeability [mol/m²•s•Pa], A is the amount of permeation [mol], Pr is the pressure [Pa] on the supply side, that is, the external gas channel 20A side, Pp is the pressure [Pa] on the permeation side, that is, the internal gas channel 20B side, S is the cross sectional area [m²], and t is the time [seconds; s]. The permeability coefficient ratio (H₂/N₂) can be calculated from the hydrogen gas permeability and the nitrogen gas permeability, that is, the following equation: α = Q_{H2}/Q_{N2}, where α is the permeability coefficient ratio (transmittance ratio), Q_{H2} is the hydrogen gas permeability, and Q_{N2} is the nitrogen gas permeability.

In this example, the hydrogen gas permeability (H₂ permeability) was measured at 300 °C, 400 °C, 500 °C, and 600 °C, and the activation energy [kJ/mol] of the hydrogen gas permeation was determined from an Arrhenius plot of the results. The H₂ permeability was also measured at 800 °C and 50 °C.

The results are summarized in Table 1 along with an outline of the method of production and the structure of the hydrogen gas separator.

**Table 1**

| | Example 1 |
|---|---|
| Porous substrate sintering temperature | 600 °C |
| Silica source | HMDS |
| Reaction temperature | 600 °C |
| Reaction time | 5 min |
| H₂ permeation activation energy [kJ/mol] | 5.9 |
| H₂ permeability (600°C) [mol/m²·s·Pa] | 7.1 × 10⁻⁷ |
| Permeability coefficient ratio (H₂/N₂) | 3.9 × 10² |
| H₂ permeability (300°C) [mol/m²·s·Pa] | 4.6 × 10⁻⁷ |
| permeability coefficient ratio (H₂/N₂) | 7.8 × 10² |
| H₂ permeability (50°C) [mol/m²· s·Pa] | 3.1 × 10⁻⁷ |
| Permeability coefficient ratio (H₂/N₂) | 0.9 × 10² |
| H₂ permeability (800°C) [mol/m² ·s·Pa] | 5.5 × 10⁻⁷ |
| Permeability coefficient ratio (H₂/N₂) | 3.0 × 10² |

Table 1 shows that the hydrogen gas separator of the example had an H₂ permeability of 7.1 × 10⁻⁷ [mol/m²•s•Pa] at 600 °C and a transmission coefficient ratio (H₂/N₂) of 3.9 × 10², indicating a good balance of H₂ permeability and permeability coefficient ratio at high levels. The hydrogen permeation activation energy was also a low level of 5.9 [kJ/mol], with a high H₂ permeability over a broad temperature range. For example, the hydrogen gas separator of this example demonstrated a high H₂ permeability of 4.6 × 10⁻⁷ [mol/m²•s•Pa] at 300 °C as well. The H₂ permeability at a measuring temperature of 800 °C was 5.5 × 10⁻⁷ [mol/m²•s•Pa], and the permeability coefficient ratio was 3.0 × 10², confirming good performance at elevated temperature (at least around 800 °C).

The hydrogen gas separator was furthermore heat treated for 60 minutes at 800 °C, and a water vapor resistance test was then conducted at a total pressure of 3 atm (about 3 × 10⁵ Pa) in a 50% H₂O, 25% H₂, and 25% N₂ atmosphere. The H₂ permeability determined at 500 °C prior to the water vapor resistance test was 3.6 × 10⁻⁷ [mol/m²•s•Pa], and the permeability coefficient ratio (H₂/N₂) was 1.5 × 10². The H₂ permeability determined at 500 °C after the 12-hour water vapor resistance test was 3.1 × 10⁻⁷ [mol/m²•s•Pa], and the permeability coefficient ratio (H₂/N₂) stayed at 1.4 × 10². These results confirmed the hydrogen gas separator of the example to have excellent water vapor resistance (hot water vapor resistance).

### <Example 2>

In this example, the reaction time (silica coat-producing time) during counter diffusion CVD was changed to 30 minutes. The hydrogen gas separator of Example 2 was in all other respects produced in the same manner as in Example 1.

The hydrogen gas separator was evaluated in the same manner as in Example 1. However, in this example, the hydrogen gas permeation activation energy was determined from an Arrhenius plot of the H₂ permeability at 300 °C, 500 °C, and 600 °C. The results are summarized in Table 2 along with an outline of the method of production and the structure of the hydrogen gas separator.

**Table 2**

| | Example 2 |
|---|---|
| Porous substrate sintering temperature | 600 °C |
| Silica source | HMDS |
| Reaction temperature | 600 °C |
| Reaction time | 30 min |
| H₂ permeation activation energy [kJ/mol] | 5.5 |
| H₂ permeability (600°C) [mol/m²·s·Pa] | 7.3 × 10⁻⁷ |
| Permeability coefficient ratio (H₂/N₂) | 2.8 × 10² |

Table 2 shows that the activation energy, H₂ permeability, and permeability coefficient ratio of the hydrogen gas separator in this example were all of about the same level as that in the hydrogen gas separator of Example 1. The results corroborate that the use of HMDS as the silica source suppressed the effect of film-forming time on hydrogen gas separation performance and thus that a hydrogen gas separator demonstrating good performance could be formed consistently (precisely).

### <Example 3>

A γ-alumina porous film (γ-alumina film) 12 was formed on the outer peripheral surface of an α-alumina support 14 in the same manner as in Example 1 except that the γ-alumina film (porous substrate) sintering temperature was changed to 800 °C. The γ-alumina film 12 was about 2 µm thick, with a peak pore diameter of 8 nm to 10 nm, as determined by common nitrogen absorption. The γ-alumina film 12 obtained as a result of the firing process at 800 °C is sometimes referred to below as "γ-alumina substrate (800 °C)". The hydrogen gas separator of Example 3 was produced by carrying out counter diffusion CVD in the same manner as in Example 1 except for the use of the γ-alumina substrate (800 °C) instead of the γ-alumina substrate (600 °C).
The hydrogen gas separator so obtained was evaluated in the same manner as in Example 1. The results are summarized in Table 3 along with an outline of the method of production and the structure of the hydrogen gas separator.

**Table 3**

| | Example 3 |
|---|---|
| Porous substrate sintering temperature | 800 °C |
| Silica source | HMDS |
| Reaction temperature | 600 °C |
| Reaction time | 5 min |
| H₂ permeation activation energy [kJ/mol] | 5.6 |
| H₂ permeability (600°C) [mol/m²·s·Pa] | 6.6 × 10⁻⁷ |
| Permeability coefficient ratio (H₂/N₂) | 3.4 × 10² |
| H₂ permeability (800°C) [mol/m²·s·Pa] | 5.0 × 10⁻⁷ |
| Permeability coefficient ratio (H₂/N₂) | 3.9 × 10² |

Table 3 shows that a good H₂ permeability and permeability coefficient ratio were also obtained with a good balance at 600 °C in this example, which was produced using the γ-alumina substrate (800 °C) having a peak pore diameter of 8 nm to 10 nm. The hydrogen permeation activation energy was also a low level of 5.5 [kJ/mol], with a high H₂ permeability over a broad temperature range. It was furthermore confirmed that the hydrogen gas separator had good performance at elevated temperature (at least 800 °C).
It can be assumed that the H₂ permeability at the measuring temperatures of 600 °C and 800 °C in this example were somewhat lower than in Example 1 because the pore diameter of the γ-alumina was greater than in Example 1, so that the silica source tended to advance into the pores, resulting in the formation of a silica coat that was thicker than in Example 1.

### <Example 4>

In this example, hexamethyl disilazane was used instead of the HMDS used in Example 1 as the silica source. The hydrogen gas separator of Example 4 was in all other respects produced in the same manner as in Example 1, and was evaluated in the same manner as in Example 1. In this example, however, the hydrogen gas permeation activation energy was determined from an Arrhenius plot of the H₂ permeability at 300 °C, 500 °C, and 600 °C. The results are summarized in Table 4 along with an outline of the method of production and the structure of the hydrogen gas separator.

**Table 4**

| | Example 4 |
|---|---|
| Porous substrate sintering temperature | 600 °C |
| Silica source | hexamethyl disilazane |
| Reaction temperature | 600 °C |
| Reaction time | 5 min |
| H₂ permeation activation energy [kJ/mol] | 4.0 |
| H₂ permeability (600°C) [mol/m²·s·Pa] | 7.7 × 10⁻⁷ |
| Permeability coefficient ratio (H₂/N₂) | 1.7 × 10² |

Table 4 shows that a good H₂ permeability and permeability coefficient ratio were also obtained at 600 °C in the hydrogen gas separator of this example, in which the silica coat was produced using a silica source having Si-N-Si bonds. The hydrogen permeation activation energy was also a low level of 4.0 [kJ/mol], with a high H₂ permeability over a broad temperature range.

### <Example 5>

In this example, the reaction temperature (silica coat-forming temperature) in the counter diffusion CVD was changed to 550 °C. The hydrogen gas separator of Example 5 was in all other respects produced in the same manner as in Example 4 (that is, hexamethyl disilazane was used as the silica source), and was evaluated in the same manner as in Example 1. The results are summarized in Table 5 along with an outline of the method of production and the structure of the hydrogen gas separator.

**Table 5**

| | Example 5 |
|---|---|
| Porous substrate sintering temperature | 600 °C |
| Silica source | hexamethyl disilazane |
| Reaction temperature | 550°C |
| Reaction time | 5 min |
| H₂ permeation activation energy [kJ/mol] | 4.1 |
| H₂ permeability (600°C) [mol/m²·s·Pa] | 9.8 × 10⁻⁷ |
| Permeability coefficient ratio (H₂/N₂) | 3.1 × 10² |

Table 5 shows that the H₂ permeability and permeability coefficient ratio of the hydrogen gas separator of this example were achieved with a better balance than that of the hydrogen gas separator in Example 4. The hydrogen permeation activation energy was also a low level of 4.1 [kJ/mol], with a high H₂ permeability over a broad temperature range.

### <Example 6>

In this example, 1,3-divinyl-tetramethyl disiloxane was used instead of the HMDS used in Example 1 as the silica source. The hydrogen gas separator of Example 6 was in all other respects produced in the same manner as in Example 1, and was evaluated in the same manner as in Example 1. The results are summarized in Table 6 along with an outline of the method of production and the structure of the hydrogen gas separator.

**Table 6**

| | Example 6 |
|---|---|
| Porous substrate sintering temperature | 600 °C |
| Silica source | 1,3-divinyl tetramethyl disiloxane |
| Reaction temperature | 600 °C |
| Reaction time | 5 min |
| H₂ permeation activation energy [kJ/mol] | 7.1 |
| H₂ permeability (600°C) [mol/m²·s·Pa] | 6.9 × 10⁻⁷ |
| Permeability coefficient ratio (H₂/N₂) | 3.8 × 10² |
| H₂ permeability (800°C) [mol/m²·s·Pa] | 5.3 × 10⁻⁷ |
| Permeability coefficient ratio (H₂/N₂) | 4.1 × 10² |

Table 6 shows that a good H₂ permeability and permeability coefficient ratio were also obtained with a good balance at 600 °C in the hydrogen gas separator of this example. The hydrogen permeation activation energy was also a relatively low level of 7.1 [kJ/mol], with a good H₂ permeability over a broad temperature range. It was furthermore confirmed that the hydrogen gas separator had good performance at elevated temperature (at least 800 °C).

### <Example 7>

In this example, a silica coat 4 was formed using HMDS as the silica source under the same conditions as in Example 1 (first vapor deposition step). The silica source was then changed to tetramethoxysilane (TMOS), and counter diffusion CVD was carried out at a film-forming temperature of 600 °C, a film-forming time of 5 minutes, an N₂ feed rate of 200 mL/min, and an O₂ feed rate of 200 mL/min to form an additional silica coat (second vapor deposition step). The hydrogen gas separator of Example 7 was in all other respects produced in the same manner as in Example 1, and was evaluated in the same manner as in Example 1. The results are summarized in Table 7 along with an outline of the method of production and the structure of the hydrogen gas separator.

**Table 7**

| | Example 7 | |
|---|---|---|
| Porous substrate sintering temperature | 600 °C | |
| Silica source | HMDS | TMOS |
| Reaction temperature | 600 °C | 600 °C |
| Reaction time | 5 min | 5 min |
| H₂ permeation activation energy [kJ/mol] | 7.0 | |
| H₂ permeability (600°C) [mol/m² ·s·Pa] | 4.8 × 10⁻⁷ | |
| Permeability coefficient ratio (H₂/N₂) | 15 × 10² | |
| H₂ permeability (800°C) [mol/m²·s·Pa] | 2.9 × 10⁻⁷ | |
| Permeability coefficient ratio (H₂/N₂) | 11 × 10² | |

Table 7 shows that, in the hydrogen gas separator of this example, the permeability coefficient ratio could be vastly improved while minimizing decreases in the H₂ permeability by forming the silica coat using HMDS and then forming another silica coat using TMOS. It was also confirmed that the performance of the hydrogen gas separator was still good at elevated temperature (at least 800 °C).

### <Comparative Example 1>

In this example, TMOS was used instead of the HMDS used in Example 1 as the silica source. The hydrogen gas separator of Comparative Example 1 was in all other respects produced in the same manner as in Example 1, and was evaluated in the same manner as in Example 1. The results are summarized in Table 8 along with an outline of the method of production and the structure of the hydrogen gas separator.

**Table 8**

| | Comparative Example 1 |
|---|---|
| Porous substrate sintering temperature | 600 °C |
| Silica source | TMOS |
| Reaction temperature | 600 °C |
| Reaction time | 5 min |
| H₂ permeation activation energy [kJ/mol] | 9.0 |
| H₂ permeability (600°C) [mol/m2·s·Pa] | 4.8 × 10⁻⁷ |
| Permeability coefficient ratio (H₂/N₂) | 8.0 × 10² |

### <Comparative Example 2>

In this example, the reaction time (silica coat-forming time) during counter diffusion CVD was changed to 120 minutes. The hydrogen gas separator of Comparative Example 2 was in all other respects produced in the same manner as in Example 1, and was evaluated in the same manner as in Example 1. The results are summarized in Table 9 along with an outline of the method of production and the structure of the hydrogen gas separator.

**Table 9**

| | Comparative Example 2 |
|---|---|
| Porous substrate sintering temperature | 600 °C |
| Silica source | TMOS |
| Reaction temperature | 600 °C |
| Reaction time | 120 min |
| H₂ permeation activation energy [kJ/mol] | 16 |
| H₂ permeability (600°C) [mol/m²·s·Pa] | 2.4 × 10⁻⁷ |
| Permeability coefficient ratio (H₂/N₂) | 24 × 10² |
| H₂ permeability (300°C) [mol/m²·s·Pa] | 0.76 × 10⁻⁷ |
| Permeability coefficient ratio (H₂/N₂) | 31 × 10² |

Tables 8 and 9 show that longer reaction times resulted in a significant increase in hydrogen permeation activation energy (in other words, H₂ permeability with greater temperature dependence) in hydrogen gas separators in which the silica coat was formed using only TMOS, a typical example of tetra-lower alkoxysilanes, as the silica source. As a result, the H₂ permeability in the hydrogen gas separator of Comparative Example 2 was far lower when the measuring temperature was changed from 600 °C to 300 °C, as shown in Table 9.

In addition, two types of hydrogen gas separators (Comparative Example 2a and Comparative Example 2b) were prepared in the same manner as in Comparative Example 1 except that the reaction times were 30 minutes and 60 minutes, respectively, and the hydrogen permeation activation energy was determined in the same manner in order to look into the effects of reaction time (film-forming time) on hydrogen permeation activation energy in cases where HMDS and cases where TMOS were used as the silica source. The activation energy was plotted relative to reaction time (Figure 6) for Examples 1 and 2 in which HMDS was used as the silica source, as well as for Comparative Examples 1, 2a, 2b, and 2 in which TMOS was used as the silica source. Figure 6 shows that, when HMDS was used as the silica source, the hydrogen permeation activation energy was stabilized sooner and was lower (that is, the H₂ permeation was less temperature dependent) than when TMOS was used as the silica source.

### <Comparative Example 3>

In this example, a γ-alumina substrate (800 °C) was used instead of the γ-alumina substrate (600 °C) used in Example 1. The hydrogen gas separator of Comparative Example 3 was in all other respects produced in the same manner as in Example 1, and was evaluated in the same manner as in Example 1. The main results are summarized in Table 10 along with an outline of the method of production and the structure of the hydrogen gas separator.

**Table 10**

| | Comparative Example 3 |
|---|---|
| Porous substrate sintering temperature | 800 °C |
| Silica source | TMOS |
| Reaction temperature | 600 °C |
| Reaction time | 120 min |
| H₂ permeation activation energy [kJ/mol] | 15 |
| H₂ permeability (600°C) [mol/m² ·s·Pa] | 19 × 10⁻⁷ |
| Permeability coefficient ratio (H₂/N₂) | 7.3 × 10² |
| H₂ permeability (300°C) [mol/m² ·s·Pa] | 0.65 × 10⁻⁷ |
| Permeability coefficient ratio (H₂/N₂) | 3.4 × 10² |

This table shows that the hydrogen permeation activation energy increased significantly as a result of longer reaction times in the hydrogen gas separator of Comparative Example 3 in which γ-alumina (800 °C) having a pore diameter fairly greater than in Comparative Example 2 was used. As a result, the H₂ permeability in the hydrogen gas separator of this example was far lower when the measuring temperature was changed from 600 °C to 300 °C, as shown in Table 10.

### INDUSTRIAL APPLICABILITY

The hydrogen gas separator produced by the method disclosed herein can be incorporated as a gas separation module in a variety of containers and devices. For example, it can be incorporated into a reformer (such as a reformer for high temperature fuel cell) as a film-type hydrogen gas separation module. The method disclosed herein is thus able to provide a hydrogen gas separator that is useful, particularly as a structural element in reformers for high temperature fuel cell systems or reactors used in various other stringent environments (such as gas separation devices for separating hydrogen from methane steam reforming reactions or reactors for separating toxic gases such as NOₓ).
It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A method for producing a hydrogen gas separator (1) by forming a silica coat (4) on a porous substrate (12), comprising the steps of:
preparing the porous substrate (12); and
forming a silica coat (4) on the substrate (12) by chemical vapor deposition in which a reaction is brought about between a silica source (2) provided to one side of the substrate (12) and an oxygen-containing gas (3) supplied to the other side of the substrate (12), wherein
the vapor deposition process is carried out using as the silica source (2) a silicon compound (a) having Si-Z-Si bonds, wherein Z is O or N, in the molecule, wherein the silicon compound (a) is selected from a group consisting of disiloxanes represented by the following Formula (1):
(R¹)₃Si-O-Si(R²)₃ (1)
where R¹ and R² are each independently selected from alkyl groups having 1 to 3 carbon atoms and alkenyl groups having 2 to 3 carbon atoms; and
disilazanes represented by the following Formula (2):
(R³)₃Si-NH-Si(R⁴)₃ (2)
where R³ and R⁴ are each independently selected from alkyl groups having 1 to 3 carbon atoms and alkenyl groups having 2 to 3 carbon atoms.

2. The method according to claim 1, wherein the porous substrate (12) is a porous film with a pore diameter of 2 nm to 20 nm provided on a surface of a porous support (14) with a pore diameter of 50 nm to 1000 nm.

3. The method according to claim 1 or 2, wherein the vapor deposition process comprises a first vapor deposition step of using as the silica source (2) the silicon compound (a) and a second vapor deposition step of using as the silica source (2) a silicon compound (b) that is different from the silicon compound (a).

## Patentansprüche

1. Verfahren zur Herstellung eines Wasserstoffgasseparators (1) durch Bilden einer Siliziumdioxidbeschichtung (4) auf einem porösen Substrat (12), umfassend die Schritte:
Herstellen des porösen Substrats (12) und
Bilden einer Siliziumdioxidbeschichtung (4) auf dem Substrat (12) durch chemische Dampfabscheidung, bei der eine Reaktion zwischen einer Siliziumdioxidquelle (2), die auf einer Seite des Substrats (12) bereitgestellt ist, und einem Sauerstoff-enthaltenden Gas (3), das der anderen Seite des Substrats (12) zugeführt wird, bewirkt wird, wobei
der Dampfabscheidungsvorgang mit einer Siliziumverbindung (a), die Si-Z-Si-Bindungen, wobei Z O oder N ist, im Molekül aufweist, als Siliziumdioxidquelle (2) durchgeführt wird, wobei die Siliziumverbindung (a) aus einer Gruppe, bestehend aus Disiloxanen, dargestellt durch die folgende Formel (1):
(R')₃Si-O-Si(R²)₃ (1)
worin R¹ und R² jeweils unabhängig aus Alkylgruppen mit 1 bis 3 Kohlenstoffatomen und Alkenylgruppen mit 2 bis 3 Kohlenstoffatomen ausgewählt sind, und
Disilazanen, dargestellt durch die folgende Formel (2):
(R³)₃Si-NH-Si(R⁴)₃ (2)
worin R³ und R⁴ jeweils unabhängig aus Alkylgruppen mit 1 bis 3 Kohlenstoffatomen und Alkenylgruppen mit 2 bis 3 Kohlenstoffatomen ausgewählt sind,
ausgewählt ist.

2. Verfahren nach Anspruch 1, bei dem das poröse Substrat (12) ein poröser Film mit einem Porendurchmesser von 2 nm bis 20 nm ist, der auf einer Oberfläche eines porösen Trägers (14) mit einem Porendurchmesser von 50 nm bis 1000 nm bereitgestellt ist.

3. Verfahren nach Anspruch 1 oder 2, bei dem der Dampfabscheidungsvorgang einen ersten Dampfabscheidungsschritt, bei dem die Siliziumverbindung (a) als Siliziumdioxidquelle (2) verwendet wird, und einen zweiten Dampfabscheidungsschritt umfasst, bei dem eine Siliziumverbindung (b), die von der Siliziumverbindung (a) verschieden ist, als Siliziumdioxidquelle (2) verwendet wird.

## Revendications

1. Procédé pour la production d'un séparateur de gaz d'hydrogène (1) en formant un revêtement de silice (4) sur un substrat poreux (12), comprenant les étapes consistant à :
préparer le substrat poreux (12) ; et
former un revêtement de silice (4) sur le substrat (12) par dépôt chimique en phase vapeur, dans lequel une réaction est déclenchée entre une source de silice (2) aménagée sur un côté du substrat (12) et un gaz contenant de l'oxygène (3) alimenté sur l'autre côté du substrat (12), dans lequel
le procédé de dépôt en phase vapeur est effectué en utilisant, comme source de silice (2), un composé de silicium (a) ayant des liaisons Si-Z-Si, où le terme Z représente O ou N, dans la molécule, le composé de silicium (a) étant sélectionné dans un groupe constitué de disiloxanes représentés par la formule (1) suivants :
(R¹)₃Si-O-Si(R²)₃ (1)
dans laquelle R¹ et R² sont sélectionnés chacun indépendamment parmi des groupements alkyle ayant 1 à 3 atomes de carbone et des groupements alcényle ayant 2 à 3 atomes de carbone; et
des disilazanes représentés par la formule (2) suivante :
(R³)₃Si-NH-Si(R⁴)₃ (2)
dans laquelle R³ et R⁴ sont sélectionnés chacun indépendamment parmi des groupements alkyle ayant 1 à 3 atomes de carbone et des groupements alcényle ayant 2 à 3 atomes de carbone.

2. Procédé selon la revendication 1, dans lequel le substrat poreux (12) est un film poreux présentant un diamètre de pore de 2 nm à 20 nm aménagé sur une surface d'un support poreux (14) présentant un diamètre de pore de 50 nm à 1000 nm.

3. Procédé selon la revendication 1 ou 2, dans lequel le procédé de dépôt en phase vapeur comprend une première étape de dépôt en phase vapeur utilisant, comme source de silice (2), le composé de silicium (a), et une seconde étape de dépôt en phase vapeur utilisant, comme source de silicium (2), un composé de silicium (b) qui est différent du composé de silicium (a).
